(19) Europäisches Patentamt
European Patent Office
Office européen des brevets

(11) **EP 2 169 799 B1**

(12) **FASCICULE DE BREVET EUROPEEN**

(45) Date de publication et mention
de la délivrance du brevet:
**04.09.2019 Bulletin 2019/36**

(51) Int Cl.:
*H02H 3/32* *(2006.01)*   *H02H 3/16* *(2006.01)*
*H02H 3/08* *(2006.01)*   *G01R 31/08* *(2006.01)*

(21) Numéro de dépôt: **09354036.7**

(22) Date de dépôt: **10.09.2009**

(54) **Détection directionnelle d'un défaut à la terre**

Bestimmung der Richtung eines Erdschluss-Fehlers

Directional detection of a ground fault

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **25.09.2008 FR 0805266
25.09.2008 FR 0805265**

(43) Date de publication de la demande:
**31.03.2010 Bulletin 2010/13**

(73) Titulaire: **Schneider Electric Industries SAS
92500 Rueil-Malmaison (FR)**

(72) Inventeurs:
• **Verneau, Guillaume
38050 Grenoble Cedex 09 (FR)**
• **Cumunel, Pascal
38050 Grenoble Cedex 09 (FR)**

(74) Mandataire: **Colette, Marie-Françoise et al
Schneider Electric Industries SAS
Service Propriété Industrielle
WTC - E1
5, place Robert Schuman
38050 Grenoble Cedex 09 (FR)**

(56) Documents cités:
**EP-A2- 1 890 165       WO-A1-2005/038474
US-A1- 2004 196 603**

**Description**

**DOMAINE TECHNIQUE**

L'invention concerne la détection directionnelle d'un défaut à la terre sans mesure de tension de la ligne. En particulier, l'invention est relative à un procédé de détection d'un défaut à la terre dans un réseau permettant en outre de déterminer si le défaut à la terre est localisé en amont ou en aval du point de détection. Le procédé selon l'invention repose sur les seuls signaux représentatifs des courants de chaque phase du réseau, dont le traitement résulte en paramètres permettant la localisation directionnelle.

Sous un autre aspect, l'invention concerne un dispositif de détection apte à mettre en oeuvre le procédé précédent. En particulier, le dispositif de détection directionnelle de défaut à la terre comprend des moyens permettant de calculer des paramètres à partir des signaux de courant de chaque phase, l'interprétation desdits paramètres donnant la localisation relative du défaut sans utiliser de valeurs représentatives de la tension entre phases, ni de valeurs représentatives des tensions simples.

L'invention concerne enfin un dispositif de signalisation de défaut et un relai de déclenchement comprenant des capteurs de courant associés à chaque phase du réseau et fournissant au dispositif de détection précédent les signaux permettant la signalisation, par exemple par voyant, ou le déclenchement d'un dispositif de coupure du réseau.

**ETAT DE LA TECHNIQUE**

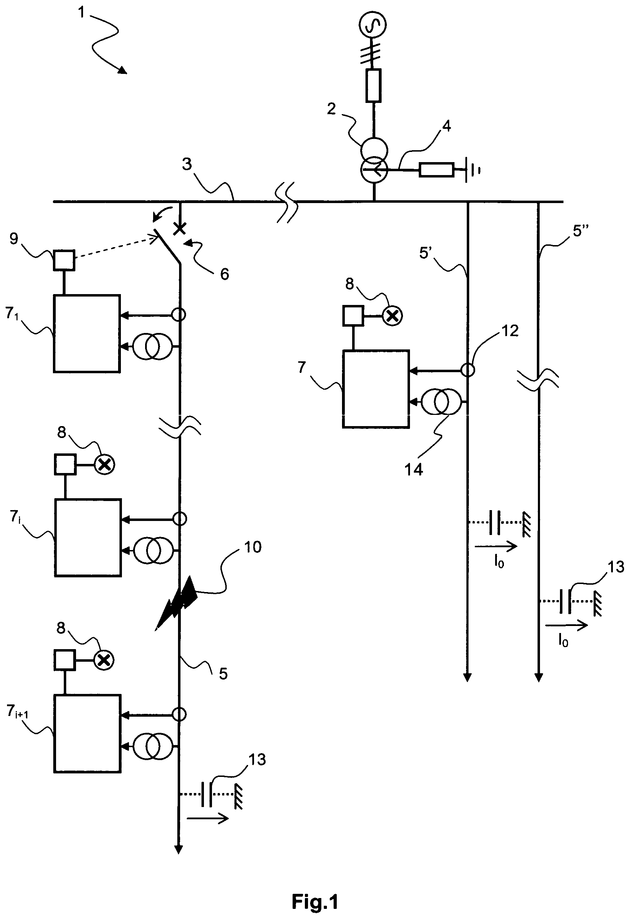

Les dispositifs de détection de défaut à la terre sont notamment utilisés dans les réseaux de distribution électrique triphasés moyenne tension. La figure 1 représente ainsi un schéma d'un réseau 1 de distribution électrique qui comporte un transformateur 2 triphasé dont le secondaire est connecté à une ligne principale 3 de distribution ; le secondaire comporte par ailleurs un conducteur commun de neutre 4 généralement connecté à la terre par une impédance. La ligne principale 3 alimente des lignes de départ 5, 5', 5", dont certaines peuvent comporter en tête un disjoncteur ou autre dispositif de coupure 6 les protégeant. Les lignes de départ 5', ou des tronçons de ligne 5, peuvent comprendre un dispositif 7 de détection de défaut à la terre. Le dispositif 7 peut servir d'indicateur de passage de défaut, allumant par exemple un voyant lumineux 8 ; un dispositif $7_1$ peut par ailleurs être associé ou intégré à un relai de protection 9 apte à commander l'ouverture des contacts du disjoncteur 6.

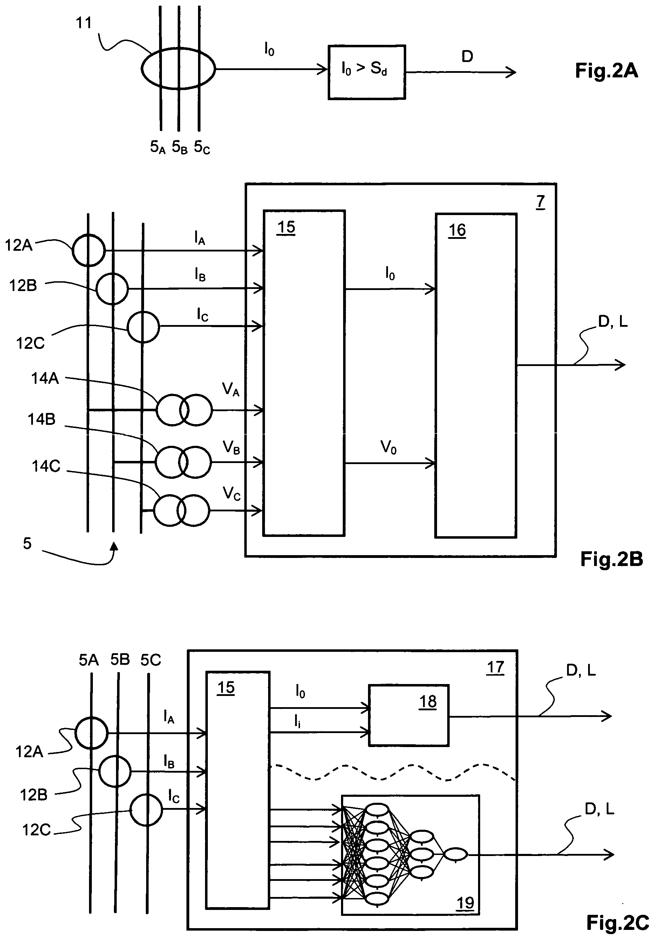

Idéalement, le réseau 1 est équilibré, c'est-à-dire que le courant homopolaire $I_0$ qui y circule est nul ; par courant homopolaire $I_0$, (ou « *zero sequence current* » selon la terminologie anglo-saxonne), on entend, à un éventuel facteur trois près, la sommation vectorielle des différents courants de phase, ou encore le courant correspondant à la résultante instantanée des courants de phase, parfois appelé courant résiduel, qui correspond éventuellement au courant de défaut à la terre (« *ground default current* » selon la terminologie anglo-saxonne) ou au courant de fuite. Si une des phases est accidentellement mise à la terre, cet équilibre disparaît en aval du défaut 10 : la détection d'un défaut peut ainsi consister, tel qu'illustré en figure 2A, en la mesure du courant homopolaire $I_0$, par exemple par un tore 11 entourant la ligne 5, et la comparaison du signal représentatif dudit courant $I_0$ avec un seuil $S_d$, le dépassement du seuil étant compris comme la détection D d'un défaut 10. Alternativement, le courant de défaut à la terre $I_0$ peut être obtenu par sommation des signaux de courant de chaque phase, un capteur de courant 12 étant alors localisé sur chaque conducteur de la ligne 5 (voir figures 2B et 2C).

Cependant, et en particulier si les lignes de départ 5 sont des câbles enterrés, de fortes valeurs de capacité peuvent apparaître entre les conducteurs de ligne $5_A$, $5_B$, $5_C$ et la terre. Ainsi, en cas de présence d'un défaut 10 à la terre sur une ligne 5, des capacités 13 sont à l'origine de la circulation d'importants courants homopolaires $I_0$ sur les autres lignes de départ 5', 5" (qui ne présentent pas de défaut à la terre), ou en aval du défaut 10. Ces (relativement) forts courants de défaut $I_0$ peuvent être à l'origine de fausses détections par les dispositifs de détection 7 présents sur les lignes voisines 5' non défaillantes.

Il importe donc de distinguer un défaut 10 localisé en aval du dispositif de détection $7_i$, d'un défaut 10 en amont du dispositif $7_{i+1}$ qui peut détecter de fait une défaillance d'un départ voisin par liaison capacitive ; cette différenciation n'est pas réalisable par le dispositif schématisé en figure 2A, surtout dans le cas d'un réseau 1 à neutre compensé (c'est-à-dire que le neutre 4 est mis à la terre par une bobine de compensation) qui génère un courant résiduel $I_0$ de valeur insuffisante, en particulier dans le cas de câbles 5 enterrés. Pour de telles détections directionnelles de défaut, les dispositifs de détection 7, tel qu'illustré plus précisément en figure 2B, se basent sur la mesure du courant mais aussi de la tension de la ligne 5. Le système de détection comprend ainsi des capteurs de courant 12A, 12B, 12C fournissant les signaux représentatifs des courants $I_A$, $I_B$, $I_C$ circulant dans chacune des phases de la ligne 5 et des capteurs de tension 14A, 14B, 14C, se présentant notamment sous la forme de transformateurs de tension, qui fournissent des signaux représentatifs des tensions $V_A$, $V_B$, $V_C$ de chaque conducteur de phase. Le dispositif de détection 7 comprend des moyens 15 qui conditionnent les données desdits capteurs 12, 14 et un module de traitement 16 qui, sur la base des signaux représentatifs du courant homopolaire $I_0$ et de la tension homopolaire $V_0$ ainsi obtenus, permet de détecter à la fois la présence D et la localisation relative L d'un défaut 10.

Cependant, les transformateurs de tension 14 sont à la fois volumineux et coûteux ; qui plus est, ils ne sont pas toujours forcément adaptés pour une installation sur des lignes 5 déjà existantes. Pour une mise en oeuvre économiquement viable, il est préférable que les dispositifs de détection de défaut 7 soient dénués de moyens de mesure 14 ou de traitement des tensions du réseau 1.

Ainsi, tel qu'illustré en figure 2C, ont été développés des dispositifs de défaut à la terre 17 dans lesquels la tension n'est pas utilisée. Par exemple, le document EP 1 475 874 présente un dispositif de détection directionnelle de défaut à la terre pour lequel le module de traitement 18 utilise, outre le signal représentatif du courant résiduel $I_0$, le signal représentatif du courant inverse $I_i$, chacun des signaux étant comparé à un seuil afin de signaler un défaut de terre en aval des capteurs de courant 12. La détection d'un défaut amont nécessite cependant une deuxième unité de traitement, et le passage en composantes complexes alourdit encore le dispositif de détection 17.

Une autre approche a été développée dans le document EP 1 890 165 dans lequel le module de traitement 19 compare la forme du courant homopolaire $I_0$ aux courants de phases $I_A$, $I_B$, $I_C$ pour déterminer si le défaut à la terre détecté est en aval ou non du dispositif de détection 17. Cette comparaison s'appuie cependant sur un réseau de neurones 19, système complexe dont la base d'apprentissage conditionne fortement le diagnostic de détection D et de direction L (une base d'apprentissage en inadéquation avec le réseau final 1 pourra conduire à des résultats de détection erronés). Qui plus est, la base d'apprentissage nécessite des coefficients (poids et facteurs de biais du réseau de neurones) figés, qui correspondent à un mode d'exploitation spécifique, comme le régime de neutre du réseau, le niveau de déclenchement du détecteur : toute modification de paramètres de réglage ou d'exploitation du dispositif de détection 17 peut alors nécessiter un nouvel apprentissage, complexe à réaliser, notamment par les équipes en charge de l'installation ou de la maintenance de tels équipements.

Il apparaît ainsi que les dispositifs de détection directionnelle de défaut à la terre 7, 17 existants ne sont pas optimisés pour une large mise en oeuvre en raison de leur complexité, que celle-ci soit due au nombre de capteurs 12, 14 à mettre en place ou au système 18, 19 de traitement des signaux.

## EXPOSE DE L'INVENTION

Un dispositif et un procédé selon l'invention sont définis dans les revendications.

Parmi autres avantages, l'invention vise à pallier des inconvénients des dispositifs et procédés de détection directionnelle de défaut à la terre existants. En particulier, le principe de directionnalité mis en oeuvre repose sur l'analyse des amplitudes ou autres valeurs normées des courants de phase, sans utilisation des tensions réseau, ni d'un échantillonnage important des signaux représentatifs desdits courants (typiquement, une fréquence d'échantillonnage inférieure à 1 kHz, par exemple de l'ordre de 500 Hz, suffit), ce qui permet de pouvoir être mis en oeuvre dans des équipements ne disposant pas de mémoire importante au niveau software et/ou hardware. Alternativement, toujours sans utilisation des différentes tensions du réseau, le principe de directionnalité mis en oeuvre peut reposer sur l'analyse de coefficients de corrélation entre le signal représentatif du courant homopolaire et les signaux représentatifs des courants de phase.

Sous un de ses aspects, l'invention est relative à un procédé de détection directionnelle de défaut à la terre dans un réseau multiphasé, de préférence triphasé, comprenant un premier stade de détection du défaut par comparaison d'un signal représentatif du courant homopolaire circulant le tronçon de ligne surveillé à un seuil de détection. Le signal représentatif du courant homopolaire peut être obtenu directement, ou par calcul à partir des signaux représentatifs des courants de chaque conducteur de phase dudit tronçon. Si le premier stade détecte la présence d'un défaut à la terre dans ledit tronçon, le deuxième stade du procédé selon l'invention est déclenché.

Le deuxième stade est basé sur le traitement des signaux représentatifs d'une norme des courants de chaque phase dudit tronçon, ces signaux étant obtenus sur une durée prédéterminée suffisante, par exemple un nombre entier de demi-périodes du réseau ; toute norme d'un courant alternatif convient pour la localisation relative selon l'invention mais, de façon préférée, la valeur efficace du courant ou son amplitude sont utilisées. Selon l'invention, les signaux représentatifs de la norme des courants de phase peuvent être fournis directement, par exemple à partir d'un capteur d'amplitude ou de valeur efficace ; alternativement, ces signaux peuvent être déterminés à partir de signaux représentatifs des courants de phase qui sont ensuite traités par tout moyen approprié pour en extraire la norme choisie.

Avantageusement, les signaux représentatifs des courants de phases sont filtrés, notamment analogiquement, et/ou échantillonnés ; selon l'invention, il est possible d'utiliser une fréquence d'échantillonnage relativement faible, notamment inférieure à 1 kHz, par exemple de l'ordre de 500 Hz.

Après l'acquisition des signaux représentatifs de la norme des courants de phase, le deuxième stade du procédé se poursuit par un traitement desdits signaux pour permettre d'interpréter si le défaut détecté dans le premier stade se situe en amont ou en aval du point de mesure des courants de phase. Le traitement des signaux comprend selon l'invention le calcul de la moyenne des signaux représentatifs des normes des courants de phase, et la comparaison de la moyenne avec chacun des signaux : si une seule norme des courants de phase après l'occurrence du défaut est supérieure à la moyenne des normes calculées pour les trois phases, alors le défaut se situe en aval de la détection.

En particulier, selon une réalisation particulière de l'invention, l'étape d'interprétation comprend la comparaison successive entre la moyenne et chacun des signaux, et la somme des sorties de comparaison, qui est comparée à l'unité : si la somme des indicateurs de comparaison prenant la valeur 1 en cas d'infériorité est égale à un, alors le défaut est en aval du point d'obtention des signaux.

Alternativement, le deuxième stade est basé sur le traitement des signaux représentatifs des courants de chaque phase dudit tronçon et du courant de défaut du même tronçon, ces signaux étant obtenus sur une durée prédéterminée suffisante, par exemple un nombre entier de demi-périodes du réseau. Avantageusement, les signaux représentatifs des courants de phase sont filtrés, notamment analogiquement, et/ou échantillonnés, de préférence à une fréquence permettant d'obtenir au moins une vingtaine de points sur la durée prédéterminée, par exemple de l'ordre de 1 kHz pour un réseau à 50 Hz et une demi-période. Le signal représentatif du courant homopolaire peut être ici aussi obtenu directement, ou par calcul à partir des signaux représentatifs des courants de chaque conducteur de phase dudit tronçon, avant ou après filtrage et/ou échantillonnage.

Après l'acquisition des signaux représentatifs de différents courants, le deuxième stade du procédé se poursuit par un traitement desdits signaux pour permettre d'interpréter si le défaut détecté dans le premier stade se situe en amont ou en aval du point de mesure des courants de phase. Le traitement des signaux comprend, selon l'invention, le calcul des coefficients de corrélation linéaire normalisés entre le signal représentatif du courant homopolaire du tronçon et chacun des signaux représentatifs des courants de phase ; de préférence, la formule de Bravais-Pearson et/ou des coefficients non signés sont utilisés. La dispersion desdits coefficients est ensuite analysée, notamment par le calcul de leur moyenne et de leur écart-type.

Si la dispersion des coefficients de corrélation linéaire non signés est élevée, par exemple avec un écart-type supérieur à 0,3 et une moyenne supérieure à 0,5, alors le défaut se situe en aval de l'appareil de détection. Inversement, pour une moindre dispersion, notamment une moyenne inférieure à 0,5 et un écart-type inférieur à 0,2, alors le défaut se situe en amont de l'appareil de détection.

De préférence, la dispersion des coefficients est réalisée par formulation d'une relation comparative. En particulier, si la différence entre l'écart-type multiplié par racine de trois et la différence entre la moyenne et un est positive, alors le défaut est en amont de la détection ; tout autre comparaison basée sur l'inégalité $3 \cdot \sigma^2 > (1 - \mu)^2$ peut être utilisée.

Selon une autre option, la comparaison est réalisée graphiquement par rapport à une droite d'équation $y = \dfrac{1 - x}{\sqrt{3}}$ : suivant que le point de coordonnées moyenne et écart-type est positionné ou non dans le demi-plan contenant l'origine, le défaut est en amont ou en aval.

Les deux options concernant le deuxième stade du procédé et sa suite peuvent être utilisées successivement ou alternativement en fonction des possibilités d'échantillonnages. En particulier, selon un mode de réalisation préféré, une étape préliminaire de vérification des possibilités d'échantillonnage est réalisée et, selon que la fréquence est par exemple supérieure ou inférieure à 1 kHz, l'option avec calcul des coefficients de corrélation ou avec détermination des normes est utilisée. Dans un autre mode de réalisation, afin d'affiner le résultat, dans un premier temps, la localisation est déterminée par les normes et, si le défaut est considéré comme localisé en aval, la localisation est confirmée par une détermination par les coefficients de corrélation.

Selon un mode de réalisation préféré selon l'invention, le(s) procédé(s) de détection directionnelle est(sont) associé(s) à un actionnement d'un dispositif de coupure pour isoler le tronçon à partir du point en aval duquel un défaut a été détecté.

Sous un autre aspect, l'invention se rapporte à un dispositif de détection directionnelle d'un défaut à la terre d'une ligne dans un réseau multiphasé, de préférence triphasé, adapté pour le(s) procédé(s) précédent(s). Le dispositif de détection directionnelle selon l'invention peut être associé à des capteurs d'amplitude, de valeur efficace ou autre norme, du courant de chacune des phases de la ligne ou des capteurs de courant de chacune des phases de la ligne, par exemple des tores de détection, qui lui fournissent les signaux représentatifs desdits courants. Le dispositif de détection directionnelle peut en outre faire partie d'un indicateur de passage de défaut, par exemple par activation de moyens d'alerte de type voyant si un défaut aval aux capteurs est détecté. Dans un mode de réalisation particulièrement préféré, le dispositif de détection directionnelle selon l'invention est associé à un relai de protection de la ligne, les moyens d'alerte provoquant l'actionnement d'un dispositif de coupure de la ligne permettant d'isoler le tronçon sur lequel un défaut a été détecté.

En particulier, le dispositif de détection directionnelle d'un défaut à la terre selon l'invention comprend des premiers moyens pour recevoir des signaux représentatifs d'une norme du courant de chaque phase de la ligne à surveiller ; les premiers moyens peuvent recevoir ledit signal directement ou comprendre des moyens pour recevoir des signaux représentatifs des courants de chaque phase et des moyens pour en déterminer la norme concernée, par exemple l'amplitude ou la valeur efficace, voire la norme *manhattan* ou la norme infinie. Avantageusement, les premiers moyens de réception des signaux représentatifs des normes des courants de phase sont associés à des moyens de filtrage desdits signaux, par exemple un filtre analogique ; de préférence, les premiers moyens comprennent des moyens d'échantillonnage pour obtenir un certain nombre de valeurs discrètes, par exemple à fréquence 500 Hz.

Le dispositif selon l'invention comprend des premiers moyens de traitement des signaux représentatifs obtenus associés à des moyens d'activation desdits premiers moyens de traitement, les moyens d'activation étant déclenchés par la détection de l'occurrence d'un défaut à la terre. De préférence, la détection de l'occurrence d'un défaut à la terre actionnant les moyens d'activation est réalisée par le dispositif selon l'invention qui comprend des moyens adaptés, notamment des deuxièmes moyens pour recevoir un signal représentatif du courant homopolaire de ladite ligne et des moyens de comparaison du signal représentatif du courant homopolaire à un seuil de détection. De préférence, les deuxièmes moyens comprennent des moyens permettant de déduire le courant homopolaire des signaux représentatifs des courants de phase ou de leur norme, notamment par sommation.

Les premiers moyens de traitement des signaux du dispositif selon l'invention comprennent des moyens pour calculer la moyenne arithmétique des signaux représentatifs des normes de chacune des phases. De préférence, les moyens de calcul sont associés à des moyens de temporisation permettant l'acquisition des signaux pendant une durée correspondant à un nombre entier de demi-périodes du réseau.

Les premiers moyens de traitement des signaux sont couplés en sortie à des premiers moyens d'interprétation qui permettent de déterminer la position relative du défaut à la terre détecté par rapport au point d'obtention desdits signaux. Les premiers moyens d'interprétation comprennent des comparateurs entre la moyenne calculée et chacun des signaux ayant servi à calculer ladite moyenne. Selon une caractéristique particulière de l'invention, les moyens d'interprétation de la comparaison de la moyenne arithmétique des normes des courants de phase avec les normes en question comportent un comparateur par phase, comparant la moyenne arithmétique et la norme de la phase concernée, un sommateur additionnant les sorties logiques des précédents comparateurs et un comparateur comparant la sortie du sommateur à la valeur un.

Alternativement, ou en complément, le dispositif de détection directionnelle d'un défaut à la terre selon l'invention comprend des troisièmes moyens pour recevoir des signaux représentatifs de courants de chaque phase de la ligne à surveiller ainsi que les deuxièmes moyens pour recevoir un signal représentatif du courant homopolaire de ladite ligne, de préférence des moyens permettant de déduire des signaux représentatifs des courants de phase, notamment par sommation, ledit signal représentatif du courant homopolaire. Avantageusement, les troisièmes moyens de réception des signaux représentatifs des courants de phase sont associés aux moyens de filtrage desdits signaux, par exemple un filtre analogique ; de préférence, les troisièmes moyens comprennent des moyens d'échantillonnage pour obtenir un nombre de valeurs discrètes suffisantes, par exemple à fréquence 1 kHz.

Le dispositif selon ce mode de réalisation de l'invention comprend des deuxièmes moyens de traitement des signaux représentatifs obtenus associés aux moyens d'activation associés auxdits premiers moyens de traitement, les moyens d'activation étant déclenchés par la détection de l'occurrence d'un défaut à la terre.

Les deuxièmes moyens de traitement des signaux du dispositif selon l'invention comprennent des moyens pour calculer les coefficients de corrélation linéaire normalisés, avantageusement non signés, de préférence selon la formule de Bravais-Pearson, entre le signal représentatif du courant homopolaire et chacun des signaux représentatifs des courants de phase. De préférence, les moyens de calcul sont associés à des moyens de temporisation permettant l'acquisition des signaux pendant une durée correspondant à un nombre entier de demi-périodes du réseau. Les données calculées sont transmises à un module de calcul de la moyenne arithmétique et de l'écart-type, couplé en sortie à des deuxièmes moyens d'interprétation comparant les résultats pour déterminer si le défaut est en amont ou en aval du point d'obtention des signaux représentatif des courants de phase ; les deuxièmes moyens d'interprétation peuvent être du type graphique ou calculatoire.

Le dispositif selon l'invention peut comprendre des moyens d'activation des deuxièmes moyens de traitement du signal en fonction du résultat obtenu par les premiers moyens d'interprétation.

Les premiers et deuxièmes moyens de traitement, ainsi que les premiers et deuxièmes moyens d'interprétation, peuvent comprendre chacun une unité indépendante ou être regroupés dans un même module apte alors à réaliser les deux procédés. En outre, les premiers et troisièmes moyens de réception - ainsi que les deuxièmes - peuvent être confondus ; dans ce cas, de préférence, des moyens de détermination de la possibilité d'échantillonnage sont présents, lesdits moyens permettant de choisir la fréquence d'échantillonnage et, en fonction de celle-ci, d'activer les premiers ou deuxièmes moyens de traitement.

## BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.

La figure 1, déjà décrite, représente un réseau électrique dans lequel des dispositifs de détection de défaut terre peuvent être utilisés.

Les figures 2A, 2B et 2C, déjà décrites, représentent des schémas blocs de dispositifs de détection de défauts à la terre selon l'art antérieur.

La figure 3 montre de façon schématique et filtrée des signaux représentatifs des courants de phase lors de l'apparition d'un défaut à la terre sur une phase, respectivement à l'amont et à l'aval du dispositif de détection.

Les figures 4A et 4B illustrent le procédé de détection selon un mode de réalisation préféré de l'invention.

La figure 5 représente un schéma bloc d'un dispositif de détection de défaut terre selon un mode de réalisation préféré de l'invention.

## DESCRIPTION DETAILLEE D'UN MODE DE REALISATION PREFERE

Le dispositif 20 de détection directionnelle de défaut 10 selon l'invention peut être utilisé dans tout réseau multiphasé 1, tel que celui décrit en figure 1, en lieu et place des dispositifs 7, 17 existants. Dans le mode de réalisation et d'utilisation préféré illustré de l'invention, la ligne 5 sur laquelle le dispositif 20 est mis en place comprend trois conducteurs de phase $5_A$, $5_B$, $5_C$ et le réseau est équilibré, c'est-à-dire que le courant homopolaire $I_0$ est nul en l'absence de défaut. Cependant, il est possible de s'écarter de cette situation idéale, et le réseau peut comprendre un autre nombre de phases.

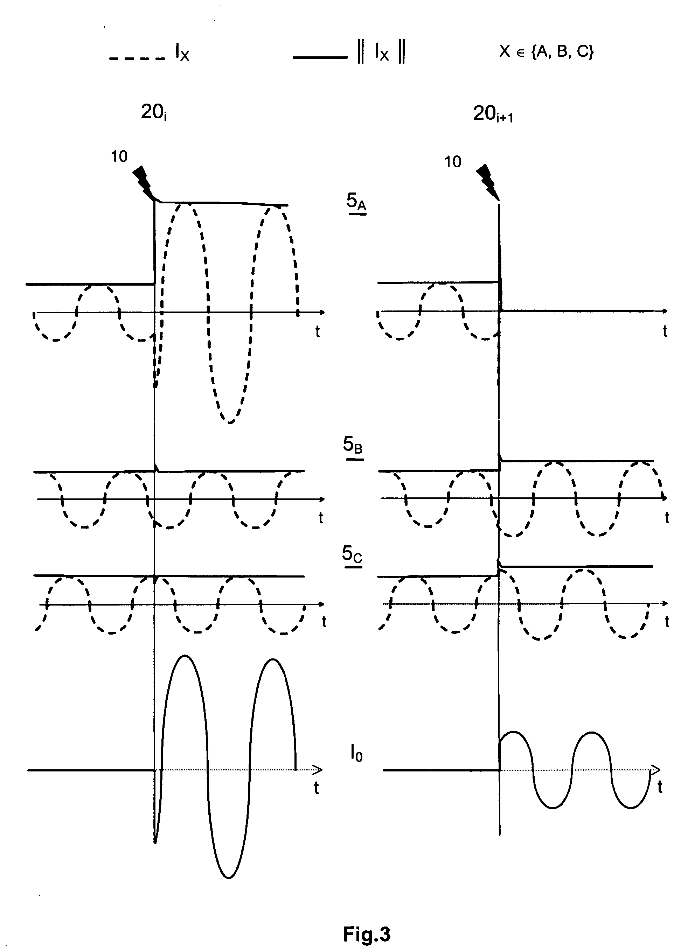

Lors de l'apparition d'un défaut à la terre 10 sur une des phases A, le courant de ladite phase $I_A$ devient (idéalement) nul en aval du défaut 10, mais est altéré en amont, en particulier en voyant son amplitude augmenter. Tel qu'illustré en figure 3, un capteur de courant 12A sur le conducteur en défaut 5A fournit ainsi un signal représentatif du courant $I_A$ (en pointillés) marquant une rupture nette au niveau du défaut 10, et différent selon que le dispositif selon l'invention est disposé en amont $20_i$ ou en aval $20_{i+1}$ dudit capteur 12. La figure 3 montre également que le courant est ponctuellement altéré dans les deux autres phases B et C, mais reste de forme quasi-constante bien que son amplitude soit légèrement modifiée. La figure 3 illustre enfin le courant homopolaire $I_0$ détecté sur la ligne 5, soit par un capteur 11 approprié (voir figure 2A), soit par calcul depuis les trois courants de phase $I_A$, $I_B$, $I_C$ obtenus par les capteurs 12.

Selon l'invention, la variation différentielle des normes du courant, comme notamment l'amplitude, est utilisée. De fait, tel que présenté en figure 3, les amplitudes des courants de phase sont quasi-constantes. Avant le défaut, l'amplitude $\|I_X\|$ de chacun des signaux de courant de phase $I_X$ est identique ; après le défaut, l'amplitude des signaux de courant des phases non altérées $\|I_B\|$, $\|I_C\|$ reste sensiblement constante ; par contre, l'amplitude du signal de courant de la phase en défaut $\|I_A\|$ est augmentée fortement dans le cas d'un défaut en aval $20_i$, et devient quasi-nulle pour un défaut en amont $20_{i+1}$. Plus particulièrement, dans le cas d'un défaut en aval $20_i$, la moyenne des amplitudes des courants post-défaut sera alors inférieure à celle du courant de la phase en défaut et supérieure aux amplitudes respectives des courants des autres phases ; *a contrario*, dans le cas d'un défaut 10 ayant lieu en amont du dispositif $20_{i+1}$, la moyenne des amplitudes des courants post-défaut sera supérieure à celle du courant de la phase A en défaut et inférieure aux amplitudes respectives des courants des deux autres phases B, C.

Selon l'invention, la moyenne des signaux représentatifs des amplitudes des courants de chaque phase est donc calculée puis sa position par rapport à ses différents composants est déterminée pour localiser le défaut 10 par rapport aux capteurs 12 fournissant des signaux représentatifs des amplitudes des courants de la ligne 5, de préférence filtrés. La localisation en tant que telle dépend du nombre de fois où la moyenne est supérieure aux signaux utilisés pour la calculer : si la moyenne des amplitudes est une seule fois supérieure aux amplitudes, le défaut est en amont. De préférence, les signaux sont analysés sur une durée suffisante $T_{acq}$, avec notamment une acquisition des signaux supérieure à une demi-période du réseau, par exemple une période ou tout nombre entier de demi-périodes.

Bien que présenté avec l'amplitude du courant, le procédé selon l'invention peut également être appliqué avec toute norme représentative de la variation du signal représentatif du courant de phase. Notamment, l'amplitude peut être remplacée par la valeur efficace (« *Root Mean Square Value* » selon la terminologie anglo-saxonne), ou par la norme euclidienne (c'est-à-dire la norme 2), ou encore par la norme 1 (également connue sous le nom de « *Taxicab norm* » ou « *Manhattan norm* »), voire la norme infinie (ou norme sup). Le signal représentatif de la valeur normée du courant de chaque phase peut être obtenu par un capteur de courant usuel 12, puis déterminée par des moyens appropriés. Selon l'invention, il est possible cependant de limiter le nombre de calculateurs, et ainsi d'utiliser un capteur d'amplitude (ou de valeur efficace) instantanée sur chaque ligne de phase 5.

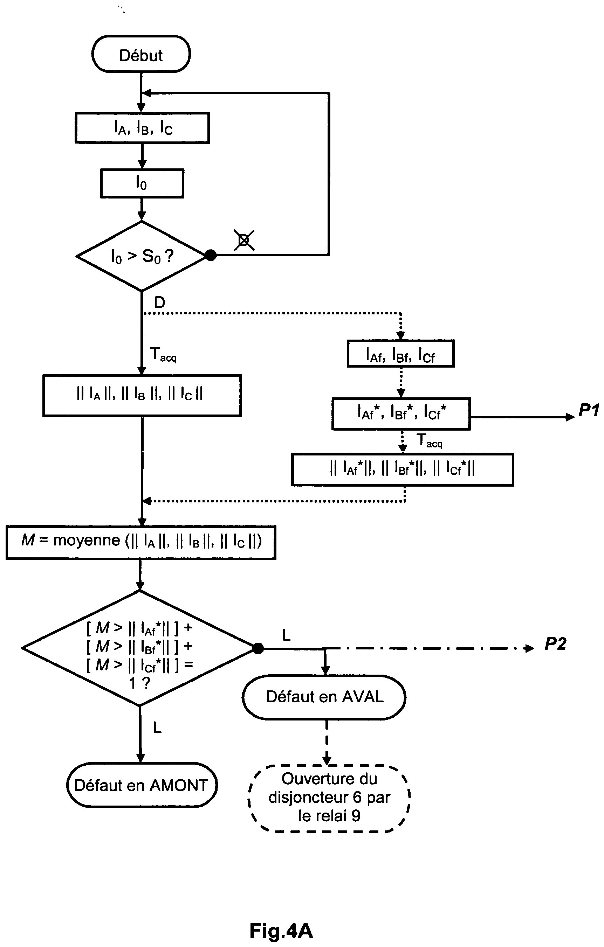

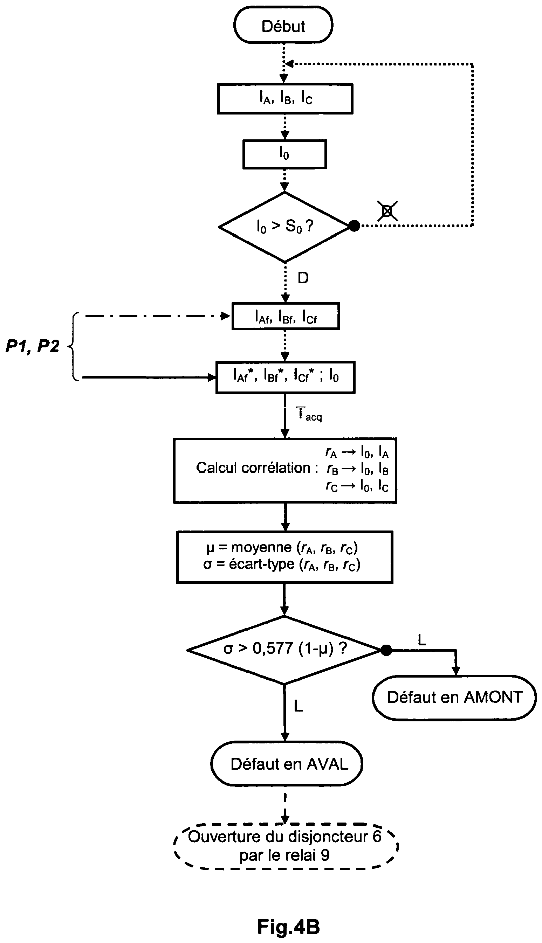

Ainsi, dans le procédé selon l'invention schématisé en figure 4, une fois le défaut détecté D, par exemple par un procédé similaire à celui décrit en relation avec la figure 2A, les signaux représentatifs des amplitudes des courants de phase $\|I_A\|$, $\|I_B\|$, $\|I_C\|$ sont acquis pour une durée d'acquisition $T_{acq}$. Alternativement, tel qu'également illustré en figure 4A, il est possible d'utiliser directement les signaux représentatifs des courants de phase, de préférence filtrés $I_{Af}$, $I_{Bf}$, $I_{Cf}$, notamment dans le cas où ceux-ci ont été mesurés par ailleurs, par exemple pour déterminer le courant homopolaire. Lesdits signaux acquis sur une durée d'acquisition $T_{acq}$ sont alors de préférence échantillonnés : de fait, il est préférable de travailler sur des valeurs discrètes à intervalles de temps réguliers ; selon l'invention, il n'est pas nécessaire que la fréquence d'échantillonnage soit élevée, et de cinq à dix valeurs d'amplitudes sur une durée de l'ordre d'une demi-période ou d'une période de réseau 1 est suffisante - une fréquence d'échantillonnage de l'ordre de 500 à 1000 Hz pour un courant triphasé à 50 Hz est par exemple adaptée au procédé selon l'invention. La norme desdits signaux échantillonnés filtrés $\|I_{Af}*\|$, $\|I_{Bf}*\|$, $\|I_{Cf}*\|$ est ensuite déterminée par les formules appropriées à la norme choisie.

Dans un mode de réalisation, une étape de vérification de la possibilité d'augmenter la fréquence d'échantillonnage est réalisée. Si le résultat de cette étape est positif et qu'un échantillonnage par exemple supérieur à 1 kHz est réalisable, le procédé peut se poursuivre *P1* par une alternative décrite plus loin pour plus de précision et selon les moyens de traitement disponibles.

Une fois les trois normes $\|I_A\|$, $\|I_B\|$, $\|I_C\|$ obtenues, leur moyenne arithmétique *M* est calculée, puis comparée à chacune des normes prises individuellement : si une seule norme $\|I_A\|$ est inférieure à la moyenne *M*, le défaut 10 est considéré comme localisé en amont. De préférence, cette dernière étape d'interprétation est réalisée par sommation des résultats de comparateurs dont les sorties sont binaires, c'est-à-dire égale à 1 si la moyenne est supérieure, et nulle si la moyenne est inférieure : la somme des résultats est comparée à l'unité, et associée à un défaut amont s'il y a égalité.

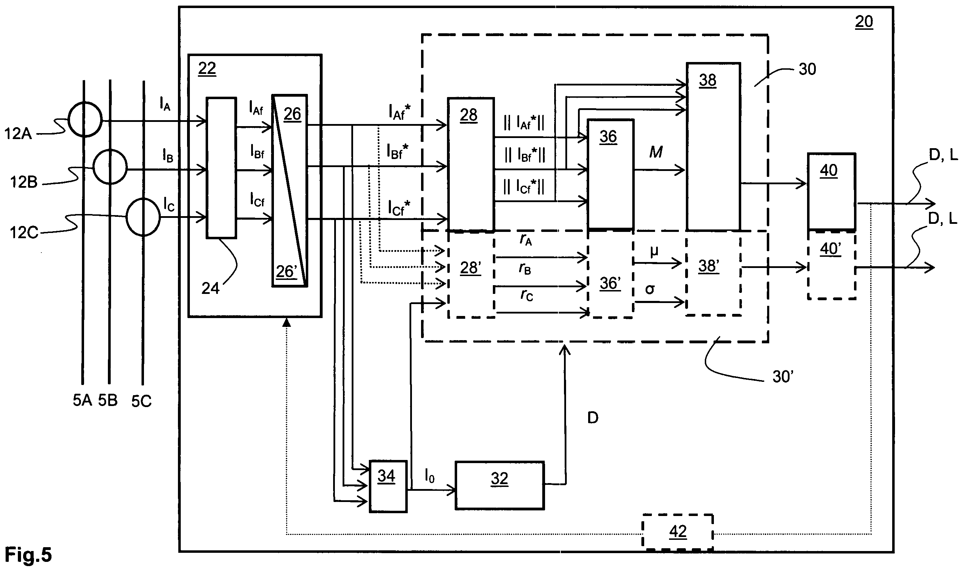

Le procédé selon l'invention peut être mis en place dans un relai de protection 9, dans un indicateur de défaut avec système d'alerte 8, par implémentation dans un dispositif de détection directionnelle de défaut à la terre 20 adapté. Un dispositif 20 selon un mode de réalisation préféré de l'invention est schématisé en figure 5. Selon le type de capteur 12 auquel il est associé, il peut comprendre des moyens 22 permettant d'obtenir des signaux représentatifs de courant de phase fournis par les capteurs, par exemple des tores de détection, avantageusement avec un filtrage par moyens 24 adaptés comme un filtre analogique. Dans le mode de réalisation préféré, les signaux filtrés $I_{Af}$, $I_{Bf}$, $I_{Cf}$ sont en outre conditionnés par échantillonnage et les moyens d'obtention des signaux représentatifs 22 comprennent un module d'échantillonnage 26, fonctionnant notamment à moins de 1 kHz, fournissant ainsi des signaux échantillonnés filtrés $I_{Af}*$, $I_{Bf}*$, $I_{Cf}*$ à des moyens de calcul 28 de leur norme, amplitude, valeur efficace ou autre, lesdites normes étant ensuite traitées au sein d'un module de traitement 30.

Le module d'échantillonnage 26 peut comprendre des moyens permettant de modifier la fréquence et/ou de vérifier qu'une fréquence supérieure à 1 kHz est réalisable ; alternativement, un deuxième module d'échantillonnage 26' pouvant fonctionner à plus de 1 kHz est présent associé à des moyens de sélection. Les moyens 26, 26' d'échantillonnage peuvent être couplés à un module de traitement alternatif 30' décrit plus loin lorsqu'ils fonctionnent à fréquence élevée.

Le module de traitement 30 est activé en fonction de la détection d'un défaut à la terre 10. A cette fin, le module de traitement 30 est connecté à un dispositif de détection de défaut 32 quelconque ; en particulier, le dispositif de détection de défaut 32 est associé à des moyens 34 d'obtention d'un signal représentatif du courant homopolaire $I_0$ et comprend un module de comparaison du courant homopolaire $I_0$ avec un seuil de détection $S_d$ : si le seuil est dépassé, alors un défaut D est détecté et le module de traitement 30 est activé. Les moyens d'obtention du courant homopolaire $I_0$ peuvent être reliés à un capteur approprié 11 (voir figure 2A), ou de préférence déterminer ledit courant par traitement des signaux relatifs aux courants de phase $I_A$, $I_B$, $I_C$ (non illustré), avantageusement filtrés $I_{Af}$, $I_{Br}$, $I_{Cf}$ (non illustré), éventuellement échantillonnés (figure 5), voire même directement depuis leur amplitude $\|I_{Af}*\|$, $\|I_{Bf}*\|$, $\|I_{Cf}*\|$ (non illustré).

De préférence, les moyens de calcul des normes 28 font partie du module de traitement 30, de sorte à n'être activés qu'après l'occurrence D d'un défaut à la terre 10. Alternativement, ces différents éléments 22, 28 pour fournir des signaux représentatifs de la norme des courants à partir de signaux représentatifs des courants peuvent être omis selon la nature des capteurs 12 : les signaux fournis par des capteurs 12 d'amplitude instantanée sont directement utilisables dans un module de traitement 30.

Le module de traitement 30 comporte ensuite successivement un dispositif de calcul 36 de moyenne arithmétique *M* des trois données entrées $\|I_{Af}*\|$, $\|I_{Bf}*\|$, $\|I_{Cf}*\|$, un dispositif de comparaison 38 avec quatre entrées, ces trois valeurs et la moyenne calculée, et qui est relié à des moyens d'interprétation 40 dont la sortie est un signal L de détection directionnelle de défaut terre en aval ou en amont des capteurs 12 selon le résultat de l'interprétation.

Les moyens 36 de calcul de la moyenne *M* sont associés à des moyens de temporisation afin de s'assurer que les signaux représentatifs des normes des courants de phase $\|I_{Af}*\|$, $\|I_{Bf}*\|$, $\|I_{Cf}*\|$ ont été acquis sur une durée suffisante $T_{acq}$, par exemple une demi-période ou une période du réseau 1, voire plus. Avantageusement, dans le cas où ces signaux sont déterminés à partir de signaux représentatifs de courant de phase $I_{Af}$, $I_{Bf}$, $I_{Cf}$, les moyens de détermination 28 sont eux aussi associés à ces moyens de temporisation, qui peuvent par exemple être couplés directement au dispositif d'activation 32.

Les moyens de comparaison 38 comparent chacune des valeurs de norme avec leur moyenne et donnent avantageusement un signal binaire selon le sens de la comparaison aux moyens d'interprétation 40. Selon le nombre de résultats nuls, les moyens d'interprétation fournissent leur signal L de localisation relative ; dans un mode de réalisation préféré, les moyens d'interprétation 40 ou les moyens de comparaison 38 comprennent des moyens de sommation des résultats binaires de la comparaison, dans cet ordre, entre la moyenne et chaque norme, le défaut étant qualifié d'amont si la somme est égale à 1 et d'aval pour une somme égale à deux.

Si l'échantillonnage peut être réalisé à fréquence suffisante, pour plus de précision, il est préférable d'utiliser, selon l'invention, les coefficients de corrélation entre les différentes courbes pour déterminer si le défaut 10 est localisé en amont ou en aval des capteurs 12 fournissant des signaux représentatifs des courants de la ligne 5, de préférence filtrés. De fait, on y constate que, après occurrence du défaut à la terre, dans le cas d'un défaut 10 ayant lieu en aval du dispositif $20_i$, la ressemblance entre le courant homopolaire $I_0$ et le courant $I_A$ de la phase en défaut est importante, au contraire de la ressemblance, moyenne, entre le courant homopolaire $I_0$ et les courants $I_B$, $I_C$ des autres phases ; ainsi, les coefficients de corrélation normalisés avec le courant homopolaire $I_0$ devraient être, en valeur absolue, proches de l'unité pour la phase A et moyens, par exemple proches de 0,5, pour les autres phases. Inversement, dans le cas d'un défaut 10 ayant lieu en amont du dispositif $20_{i+1}$, après son occurrence, la ressemblance du courant homopolaire $I_0$ avec le courant $I_A$ de la phase en défaut est faible alors que la ressemblance entre le courant homopolaire $I_0$ et les courants $I_B$, $I_C$ des autres phases reste moyenne ; ainsi, les coefficients de corrélation normalisés non signés avec le courant homopolaire $I_0$ devraient rester moyens, par exemple proches de 0,5, pour les phases B et C, et être proche de zéro pour la phase A. De préférence, ici encore, les signaux sont analysés sur une durée suffisante $T_{acq}$, avec notamment acquisition des signaux supérieure à une demi-période du réseau, par exemple une période ou tout nombre entier de demi-périodes.

Le coefficient de corrélation linéaire normalisé utilisé dans le procédé selon l'invention est de préférence obtenu par la formule de Bravais-Pearson et non signé : de fait, les capteurs 12 fournissent un signal de courant alternatif circulant dans chacune des phases $5_A$, $5_B$, $5_C$ qu'il est préféré d'échantillonner de façon à obtenir un nombre défini de valeurs discrètes représentatives du courant. Avantageusement, le nombre N de valeurs fourni par l'échantillonnage est adapté à la durée d'acquisition $T_{acq}$ pour optimiser la reproductibilité et la fiabilité des résultats de la formule de Bravais-Pearson, c'est-à-dire de préférence plus de 20 valeurs dans le cas d'une durée d'acquisition $T_{acq}$ égale à une demi-période réseau, avec par exemple une fréquence d'échantillonnage de l'ordre du kilohertz pour un réseau 1 triphasé à 50 Hz.

Ainsi, dans le procédé selon l'invention schématisé en figure 4, une fois le défaut détecté D, par exemple par un procédé similaire à celui décrit en relation avec la figure 2A, les signaux représentatifs des courants de phase, de préférence filtrés, sont acquis sur une durée d'acquisition $T_{acq}$, puis échantillonnés ; parallèlement, le courant homopolaire $I_0$ est calculé pour la même durée. Les coefficients de corrélation, ici non signés, entre les signaux représentatifs des courants de phases filtrés échantillonnés $I_{Af}^*$, $I_{Bf}^*$, $I_{Cf}^*$ et le signal représentatif du courant homopolaire $I_0$ sont calculés par la formule de Bravais-Pearson selon l'équation (1), dans laquelle $r_{XY}$ désigne l'indice de corrélation linéaire non signé entre les deux variables X, Y dont respectivement N valeurs ponctuelles x, y sont connues.

$$(1) \quad r_{XY} = \left| \frac{\sum\limits_{k=1}^{N}\left(x_k - \frac{\sum\limits_{i=1}^{N}x_i}{N}\right) \times \left(y_k - \frac{\sum\limits_{i=1}^{N}y_i}{N}\right)}{\sqrt{\sum\limits_{k=1}^{N}\left(x_k - \frac{\sum\limits_{i=1}^{N}x_i}{N}\right)^2} \times \sqrt{\sum\limits_{k=1}^{N}\left(y_k - \frac{\sum\limits_{i=1}^{N}y_i}{N}\right)^2}} \right|$$

On obtient ainsi trois coefficients de corrélation linéaire normalisés non signés $r_A$, $r_B$, $r_C$. Tel qu'indiqué plus haut, suivant que le défaut 10 est en amont ou en aval, les coefficients $r_A$ sont plus proches de 1 ou de 0. Suivant l'invention, pour évaluer cette proximité, la moyenne arithmétique $\mu$ et l'écart-type $\sigma$ de la distribution des coefficients de corrélation sont utilisés. De fait, un couple moyenne/écart-type $(\mu, \sigma)$ à valeurs élevées (par exemple $\mu > 0,5$ et $\sigma > 0,3$) correspond à un défaut aval, contrairement à un couple moyenne/écart-type $(\mu, \sigma)$ à valeurs faibles (par exemple $\mu < 0,5$ et $\sigma < 0,2$) qui correspond à un défaut amont.

Plus particulièrement, on constate que, pour un défaut 10 en aval de la détection $20_i$, est vérifiée la relation suivante (2), alors que pour un défaut amont 10, $20_{i+1}$, l'inverse est vrai, c'est-à-dire : $3 \cdot \sigma^2 < (1 - \mu)^2$.

$$(2) \quad \sqrt{3} \times \sigma > (1 - \mu)$$

Dans un procédé préféré selon l'invention, une fois la moyenne et l'écart-type calculés, la comparaison selon la relation (2), ou toute relation qui en dérive directement, est effectuée et, selon le résultat, l'interprétation directionnelle L quant à la position du défaut est donnée, soit signalée à l'extérieur, soit transmise à un relai 9 pour couper un disjoncteur 6 en amont, ou tout autre utilisation.

Pour alléger cette étape de calcul du procédé selon l'invention, il est possible graphiquement de déterminer la localisation relative aval ou amont du défaut 10 en positionnant le point de coordonnées $(\mu,\sigma)$ sur un graphe (x,y) où est tracée une droite d'équation (3) : si le point est situé dans le demi-plan contenant l'origine (0,0), il s'agit d'un défaut amont.

$$(3) \qquad y = \frac{1 - x}{\sqrt{3}}$$

Pour implémenter ce procédé selon l'invention, un dispositif de détection directionnelle de défaut à la terre adapté peut être réalisé ; selon un mode de réalisation préféré de l'invention schématisé en figure 5, le dispositif précédent 20 est complété par les moyens indiqués. En particulier, le module d'échantillonnage 26' fonctionne avantageusement à plus de 1 kHz, fournissant ainsi des signaux échantillonnés filtrés à traiter $I_{Af}{}^{*}$, $I_{Bf}{}^{*}$, $I_{Cf}{}^{*}$ ; les deux modules 26, 26' d'échantillonnage peuvent être confondus et comprendre des moyens de sélection de la fréquence. Les signaux représentatifs des courants de phases échantillonnés filtrés $I_{Af}{}^{*}$, $I_{Bf}{}^{*}$, $I_{Cf}{}^{*}$ sont transmis à un deuxième module de traitement 30' qui comprend en outre une quatrième entrée pour le signal représentatif du courant homopolaire $I_0$. Le deuxième module de traitement 30' peut être confondu avec le module de traitement 30 précédent.

Le module de traitement 30' comporte ainsi successivement un dispositif de calcul 28' de coefficients de corrélation normalisés non signés r à partir des quatre signaux d'entrée $I_{Af}{}^{*}$, $I_{Bf}{}^{*}$, $I_{Cf}{}^{*}$, $I_0$, un dispositif de calcul 36' de la moyenne arithmétique $\mu$ et de l'écart-type $\sigma$ des trois données entrées $r_A$, $r_B$, $r_C$, un dispositif de comparaison 38' avec deux entrées $\mu$, $\sigma$ et qui est relié à des deuxièmes moyens d'interprétation 40' dont la sortie est un signal L de détection directionnelle de défaut terre en aval ou en amont des capteurs 12 selon le résultat de l'interprétation. Le dispositif de calcul des coefficients de corrélation 28' peut être intégré au dispositif de calcul 28 de la norme des signaux ou composer une entité indépendante ; les dispositifs de calcul 36' et de comparaison 38', respectivement les deuxièmes moyens d'interprétation 40, relatifs aux coefficients de corrélation peuvent de la même façon être intégrés ou non aux dispositifs de calcul 36 et de comparaison 38, respectivement aux premiers moyens d'interprétation 40, relatifs aux normes.

Les moyens de calcul de coefficients de corrélation normalisés non signés 28' utilisent de préférence la formule (1) de Bravais-Pearson et sont associés à des moyens de temporisation afin de s'assurer que les signaux représentatifs des courants de phase $I_{Af}{}^{*}$, $I_{Bf}{}^{*}$, $I_{Cf}{}^{*}$ ont été acquis sur une durée suffisante $T_{acq}$, par exemple une demi-période ou une période du réseau 1, voire plus.

Les moyens de comparaison 38' fournissant la valeur au module d'interprétation 40' peuvent utiliser différentes fonctions. En particulier, les moyens de comparaison 38' peuvent comprendre une comparaison graphique par des deux valeurs entrées par rapport à un demi-plan délimité par la droite d'équation (3) ; les moyens 38' peuvent déterminer la différence entre le triple du carré de l'écart-type et le carré de la différence entre un et la moyenne, pour la comparer à zéro ; toute autre option est possible.

Le dispositif de la figure 5 peut être avantageusement associé à un relai de protection 9 pour des réseaux électriques, ou à un indicateur de passage de défaut pour des lignes 5 moyenne tension souterraines connectées en réseau 1, la sortie du module d'interprétation déclenchant la coupure d'un disjoncteur 6, l'allumage d'un voyant 8 ou tout autre moyen de sécurité et/ou d'alerte.

Ainsi, selon l'invention, un procédé et un dispositif de détection directionnelle 20 d'un défaut à la terre 10 d'une ligne d'un réseau multiphasé 1 ont été réalisés sans mesure de tension, ce qui allège autant les dispositifs que leur mise en oeuvre. Qui plus est, l'échantillonnage utilisé pour un traitement des signaux selon l'invention peut être restreint, notamment de fréquence comprise entre 500 et 1000 Hz, présentant ainsi des facilités en termes de mémoire et de processeur pour ledit dispositif. Le procédé peut par ailleurs être adapté en fonction des possibilités d'échantillonnage.

Par ailleurs, même lorsque les moyens d'échantillonnage 26 sont suffisants pour une fréquence supérieure à 1 kHz, il est possible d'utiliser les deux calculs pour accélérer la localisation. En effet, la méthode utilisant les normes nécessite moins de calculs : la rapidité dans la détermination préliminaire de la localisation L peut être avantageuse. Si les premiers moyens d'interprétation 40 ne diagnostiquent pas un défaut en amont cependant, il peut être préférable de valider le résultat par une deuxième détermination P2 plus longue et nécessitant plus de mémoire par l'intermédiaire des coefficients de corrélation : des moyens adaptés 42 activent alors les moyens d'échantillonnage 26' et/ou directement les deuxièmes moyens de traitement 28' pour confirmer la localisation en aval.

Bien que l'invention ait été décrite en référence à un réseau de distribution triphasé dans lequel le neutre est mis à la terre par impédance compensée, elle ne s'y limite pas : d'autres types de réseaux multiphasés peuvent être concernés par l'invention ; en particulier, tout régime de neutre est approprié. Par ailleurs, bien que décrit avec détermination et traitement du courant homopolaire instantané $I_0$, le procédé selon l'invention peut utiliser la variation dudit courant $I_0$ par rapport à sa valeur déterminée sur une période préalable : cette variante s'avère particulièrement intéressante dans le cas de réseaux présentant un léger déséquilibre entre phases, dont le courant homopolaire $I_0$ est donc non nul en situation hors défaut.

De fait, les différents circuits, modules et fonctions présentés dans le cadre du mode de réalisation préféré de l'invention peuvent être réalisés en composants analogiques, numériques ou sous une forme programmable opérant avec des microcontrôleurs ou des microprocesseurs, et les signaux représentatifs décrits peuvent avoir des formes de signaux électriques ou électroniques, de valeurs de données ou d'information dans des mémoires ou des registres, de signaux optiques visualisables notamment sur des voyants ou des écrans, ou de signaux mécaniques agissant avec des actionneurs. De même, les capteurs de courant peuvent être différents des transformateurs décrits, comme des capteurs à effet Hall ou des magnétorésistances.

**Revendications**

1. Dispositif (20) de détection directionnelle d'un défaut à la terre (10) dans un réseau multiphasé (1) **caractérisé en ce qu'**il comporte :

    - des premiers moyens pour recevoir des signaux représentatifs d'une norme du courant ($\|I_A\|$, $\|I_B\|$, $\|I_C\|$) de chacune des phases ;
    - des deuxièmes moyens (34) pour recevoir un signal représentatif du courant homopolaire ($I_0$) de l'ensemble des phases,
    - des premiers moyens (30) de traitement des signaux représentatifs de la norme du courant ($\|I_A\|$, $\|I_B\|$, $\|I_C\|$) comprenant des moyens (36) de calcul de la moyenne (*M*) des normes ($\|I_A\|$, $\|I_B\|$, $\|I_C\|$) sur une durée prédéterminée ($T_{acq}$) ;
    - des moyens d'activation (32) desdits premiers moyens de traitement (30) en fonction d'un signal (D) de détection de l'occurrence d'un défaut à la terre dans le réseau (1), lesdits moyens d'activation (32) étant associés aux deuxièmes moyens (34),
    - des premiers moyens (40) d'interpretation des résultais du traitement des signaux pour déterminer si le défaut est en amont ou en aval du dispositif (20), comprenant des moyens de comparaison de ladite moyenne (*M*) avec lesdites normes ($\|I_A\|$, $\|I_B\|$, $\|I_C\|$), si une seule norme des courants de phase après l'occurrence du défaut est supérieure à la moyenne des normes calculées pour les trois phases le défaut étant considéré en aval de la détection, si une seule norme est inférieure à la moyenne (*M*), le défaut (10) étant considéré comme localisé en amont.

2. Dispositif de détection directionnelle (20) selon la revendications 1 dans lequel les moyens (36) de calcul de la moyenne (*M*) des normes sont associés à des moyens d'acquisition des signaux pendant une durée ($T_{acq}$) correspondant à un nombre entier de demi-périodes du réseau (1).

3. Dispositif de détection directionnelle (20) selon l'une des revendications 1 à 2 dans lequel les premiers moyens de réception des signaux représentatifs de la norme du courant ($\|I_A\|$, $\|I_B\|$, $\|I_C\|$) de chacune des phases comprennent des moyens de réception des signaux représentatifs du courant ($I_A$, $I_B$, $I_C$) de chacune des phases et des moyens de calcul (28) d'une norme de chacun des signaux représentatifs, et les premiers moyens de réception de signaux représentatifs des courants de chaque phase ($\|I_A\|$, $\|I_B\|$, $\|I_C\|$) comprennent des moyens d'échantillonnage (26).

4. Dispositif (20) de détection directionnelle selon la revendication 1 comprenant en outre :

    - des troisièmes moyens (22) pour recevoir des signaux représentatifs du courant ($I_A$, $I_B$, $I_C$) de chacune des phases ;
    - des deuxièmes moyens (30') de traitement des signaux ($I_0$, $I_A$, $I_B$, $I_C$) représentatifs de courant comprenant des moyens (28') de calcul des coefficients de corrélation normalisés ($r_A$, $r_B$, $r_C$) entre le signal représentatif du courant homopolaire ($I_0$) et chacun des signaux représentatifs de courants de phase ($I_A$, $I_B$, $I_C$) sur une durée prédéterminée ($T_{acq}$), et des moyens (36') de calcul de la moyenne ($\mu$) et de l'écart-type ($\sigma$) entre la valeur absolue des coefficients de corrélation calculés ($r_A$, $r_B$, $r_C$) ;
    - des moyens d'activation desdits deuxièmes moyens de traitement (30') en fonction d'un signal (D) de détection de l'occurrence d'un défaut à la terre dans le réseau (1) ;
    - des deuxièmes moyens (40') d'interprétation des résultats du traitement des signaux pour déterminer si le défaut est en amont ou en aval du dispositif comprenant des moyens de comparaison de ladite moyenne ($\mu$)

et dudit écart-type (σ).

**5.** Dispositif de détection directionnelle (20) selon la revendication 4 dans lequel les moyens de calcul des coefficients de corrélation (28') sont associés à des moyens d'acquisition des signaux pendant une durée ($T_{acq}$) correspondant à un nombre entier de demi-périodes du réseau (1), et les troisièmes moyens de réception (22) de signaux représentatifs des courants de chaque phase ($I_A$, $I_B$, $I_C$) comprennent des moyens d'échantillonnage (26') adaptés à fournir un nombre de valeurs suffisant pendant la durée prédéterminée ($T_{acq}$).

**6.** Dispositif selon l'une des revendications 1 à 5 comprenant en outre des moyens (32) de détection de l'occurrence d'un défaut à la terre (10) dans le réseau (1) reliés aux moyens d'activation des moyens de traitement des signaux (30) comprenant un comparateur du signal représentatif du courant homopolaire ($I_0$) à un seuil de détection ($S_d$).

**7.** Indicateur de passage de défaut à la terre comprenant des capteurs de courant ($12_A$, $12_B$, $12_C$) disposés sur chaque conducteur de phase ($5_A$, $5_B$, $5_C$) d'un réseau électrique (1) à surveiller et comprenant un dispositif de détection directionnelle de défaut (20) selon l'une des revendications 1 à 6 connecté auxdits capteurs de courant ($12_A$, $12_B$, $12_C$) pour recevoir les signaux représentatifs de courant de phase ($I_A$, $I_B$, $I_C$).

**8.** Relai (9) de protection à la terre comprenant au moins un indicateur de défaut selon la revendication 7 et des moyens d'actionnement d'un dispositif de coupure (6) en fonction des résultats des moyens d'interprétation (40) du dispositif de détection directionnelle (20) de l'indicateur.

**9.** Procédé de détection directionnelle (D, L) d'un défaut à la terre (10) dans un réseau multiphasé (1) comprenant le déclenchement, suite à l'obtention d'un signal (D) indicateur de la présence dudit défaut à la terre (10), de la détermination directionnelle (L) du défaut (10), ladite détermination directionnelle comprenant les étapes successives de :

- obtention de signaux représentatifs d'une norme de chacun des courants de phase ($\|I_A\|$, $\|I_B\|$, $\|I_C\|$) sur une durée ($T_{acq}$) d'au moins une demi-période du réseau ;
- traitement des signaux représentatifs de la norme des courants de phase ($\|I_A\|$, $\|I_B\|$, $\|I_C\|$, comprenant le calcul de la moyenne arithmétique (*M*) des signaux représentatifs de la norme de chacun des courants de phase ($\|I_A\|$, $\|I_B\|$, $\|I_C\|$) sur la durée prédéterminée ($T_{acq}$) ;
- interprétation des résultats du traitement des signaux, pour indiquer si le défaut détecté (D) se situe en aval ou en amont de l'endroit où les signaux représentatifs des normes des courants de phase ($\|I_A\|$, $\|I_B\|$, $\|I_C\|$) ont été obtenus, par une comparaison entre ladite moyenne (*M*) et lesdits signaux représentatifs de la norme de chacun des courants de phase ($\|I_A\|$, $\|I_B\|$, $\|I_C\|$).

**10.** Procédé de détection directionnelle selon la revendication 9 dans lequel l'étape d'obtention de signaux représentatifs de la norme de chacun des courants de phase ($\|I_A\|$, $\|I_B\|$, $\|I_C\|$) sur une durée ($T_{acq}$) comprend l'obtention de signaux représentatifs de chacun des courants de phase ($I_A$, $I_B$, $I_C$) et le calcul de leur norme.

**11.** Procédé de détection directionnelle selon l'une des revendications 9 ou 10 dans lequel l'étape de fourniture des signaux représentatifs des normes des courants de phase ($\|I_A\|$, $\|I_B\|$, $\|I_C\|$) comporte un échantillonnage du courant à fréquence inférieure à 1 kHz.

**12.** Procédé de détection directionnelle selon la revendication 10 dans lequel l'étape de fourniture des signaux représentatifs des courants de phase ($I_A$, $I_B$, $I_C$) comporte un échantillonnage du courant à fréquence supérieure à 1 kHz et comprenant en outre les étapes successives de :

- obtention d'un signal représentatif du courant homopolaire ($I_0$) circulant dans le réseau sur la même durée ($T_{acq}$) ;
- calcul des coefficients de corrélation normalisés non signés ($r_A$, $r_B$, $r_C$) entre les signaux de courant homopolaire ($I_0$) et de chacun des courants de phase ($I_A$, $I_B$, $I_C$) sur la durée prédéterminée ($T_{acq}$) ;
- calcul de la moyenne arithmétique (μ) et de l'écart-type (σ) desdits coefficients de corrélation ($r_A$, $r_B$, $r_C$) ;
- interprétation des résultats du traitement des signaux pour indiquer si le défaut détecté (D) se situe en aval ou en amont de l'endroit où les signaux représentatifs des courants de phase ($I_A$, $I_B$, $I_C$) ont été obtenus par une comparaison utilisant ladite moyenne (μ) et ledit écart-type (σ).

**13.** Procédé de détection directionnelle selon la revendication 12 dans lequel l'étape d'interprétation comprend la comparaison avec zéro de la différence entre le triple du carré de l'écart-type ($\sigma$) et le carré de la différence entre la moyenne ($\mu$) et un, alternativement la comparaison graphique de la moyenne ($\mu$) et de l'écart-type ($\sigma$) avec une droite d'équation $y = \dfrac{1 - x}{\sqrt{3}}$.

14. Procédé de protection d'une ligne de courant (5) lors de l'apparition d'un défaut à la terre (10) comprenant l'actionnement d'un dispositif de coupure (6) de ladite ligne (5) si un défaut à la terre (10) a été détecté par un procédé selon l'une des revendications 19 à 13 à l'aval dudit dispositif de coupure (6).

**Patentansprüche**

1. Vorrichtung (20) zum Bestimmen der Richtung eines Erdschluss-Fehlers (10) in einem Mehrphasennetz (1), **dadurch gekennzeichnet, dass** sie aufweist:

   - erste Mittel zum Empfangen der Signale, die für einen Betrag des Stroms ($\|I_A\|$, $\|I_B\|$, $\|I_C\|$) von jeder der Phasen repräsentativ sind;
   - zweite Mittel (34) zum Empfangen eines Signals, das für den homopolaren Strom ($I_0$) aller Phasen repräsentativ ist,
   - erste Mittel zum Verarbeiten (30) der Signale, die für den Betrag des Stroms ($\|I_A\|$, $\|I_B\|$, $\|I_C\|$) repräsentativ sind, umfassend Mittel (36) zum Berechnen des Mittelwerts ($M$) der Beträge ($\|I_A\|$, $\|I_B\|$, $\|I_C\|$) über eine vorbestimmte Zeitdauer ($T_{acq}$);
   - Aktivierungsmittel (32) der ersten Mittel zum Verarbeiten (30) in Abhängigkeit von einem Signal (D) zum Erkennen des Auftretens eines Erdschluss-Fehlers in dem Netz (1), wobei die Aktivierungsmittel (32) mit den zweiten Mitteln (34) verbunden sind,
   - erste Mittel (40) zum Auswerten der Ergebnisse der Signalverarbeitung, um zu bestimmen, ob der Fehler vorgelagert oder nachgelagert nach der Vorrichtung (20) vorliegt, umfassend Mittel zum Vergleichen des Mittelwerts ($M$) mit den Beträgen ($\|I_A\|$, $\|I_B\|$, $\|I_C\|$), wobei, wenn ein einziger Betrag der Phasenströme nach dem Auftreten des Fehlers größer als der Mittelwert der Beträge ist, die für die drei Phasen berechnet werden, der Fehler als nachgelagert nach dem Erkennen angesehen wird, wenn ein einziger Betrag niedriger als der Mittelwert ($M$) ist, der Fehler (10) als vorgelagert lokalisiert angesehen wird.

2. Vorrichtung zum Bestimmen der Richtung (20) nach Anspruch 1, wobei die Mittel (36) zum Berechnen des Mittelwerts ($M$) der Beträge mit Mitteln zum Erfassen der Signale während einer Zeitdauer ($T_{acq}$) verbunden sind, die einer ganzen Zahl von Halbperioden des Netzes (1) entspricht.

3. Vorrichtung zum Bestimmen der Richtung (20) nach einem der Ansprüche 1 bis 2, wobei die ersten Mittel zum Empfangen der Signale, die für den Betrag des Stroms ($\|I_A\|$, $\|I_B\|$, $\|I_C\|$) von jeder der Phasen repräsentativ sind, Mittel zum Empfangen der Signale, die für den Strom ($I_A$, $I_B$, $I_C$) von jeder der Phasen repräsentativ sind, und Mittel zum Berechnen (28) eines Betrags von jedem der repräsentativen Signale aufweist, und die ersten Mittel zum Empfangen von Signalen, die für die Ströme von jeder Phase ($\|I_A\|$, $\|I_B\|$, $\|I_C\|$) repräsentativ sind, Abtastmittel (26) aufweisen.

4. Vorrichtung (20) zum Bestimmen der Richtung nach Anspruch 1, ferner umfassend:

   - dritte Mittel (22) zum Empfangen der Signale, die für den Strom ($I_A$, $I_B$, $I_C$) von jeder der Phasen repräsentativ sind;
   - zweite Mittel (30') zum Verarbeiten der Signale ($I_0$, $I_A$, $I_B$, $I_C$), die für Strom repräsentativ sind, umfassend Mittel (28') zum Berechnen der normalisierten Korrelationskoeffizienten ($r_A$, $r_B$, $r_C$) zwischen dem Signal, das für den homopolaren Strom ($I_0$) repräsentativ ist, und jedem der Signale, die für die Phasenströme ($I_A$, $I_B$, $I_C$) über eine vorbestimmte Zeitdauer ($T_{acq}$) repräsentativ sind, und Mittel (36') zum Berechnen des Mittelwerts ($\mu$) und der Standardabweichung ($\sigma$) zwischen dem Absolutwert der berechneten Korrelationskoeffizienten ($r_A$, $r_B$, $r_C$);
   - Aktivierungsmittel der zweiten Mittel zum Verarbeiten (30') in Abhängigkeit von einem Signal (D) zum Erkennen des Auftretens eines Erdschluss-Fehlers in dem Netz (1);
   - zweite Mittel (40') zum Auswerten der Ergebnisse der Signalverarbeitung, um zu bestimmen, ob der Fehler vorgelagert oder nachgelagert nach der Vorrichtung vorliegt, umfassend Mittel zum Vergleichen des Mittelwerts

($\mu$) und der Standardabweichung ($\sigma$).

5. Vorrichtung zum Bestimmen der Richtung (20) nach Anspruch 4, wobei die Mittel zum Berechnen der Korrelationskoeffizienten (28') mit Mitteln zum Erfassen der Signale während einer Zeitdauer ($T_{acq}$) verbunden sind, die einer ganzen Zahl von Halbperioden des Netzes (1) entspricht, und die dritten Mittel zum Empfangen (22) von Signalen, die für die Ströme von jeder Phase ($I_A$, $I_B$, $I_C$) repräsentativ sind, Abtastmittel (26') aufweisen, die geeignet sind, eine ausreichende Anzahl von Werten während der vorbestimmten Zeitdauer ($T_{acq}$) bereitzustellen.

6. Vorrichtung nach einem der Ansprüche 1 bis 5, ferner umfassend Mittel (32) zum Erkennen des Auftretens eines Erdschluss-Fehlers (10) in dem Netz (1), die an die Aktivierungsmittel der Mittel zum Verarbeiten der Signale (30) angeschlossen sind, umfassend einen Komparator des Signals, das für den homopolaren Strom ($I_0$) bei einem Erfassungsschwellenwert ($S_d$) repräsentativ ist.

7. Durchgangsindikator eines Erdschluss-Fehlers, umfassend Stromsensoren ($12_A$, $12_B$, $12_C$), die auf jedem Phasenleiter ($5_A$, $5_B$, $5_C$) eines zu überwachenden Stromnetze (1) angeordnet sind, und umfassend eine Vorrichtung zum Bestimmen der Richtung eines Erdschluss-Fehlers (20) nach einem der Ansprüche 1 bis 6, die an die Stromsensoren ($12_A$, $12_B$, $12_C$) angeschlossen ist, um die Signale zu empfangen, die für einen Phasenstrom ($I_A$, $I_B$, $I_C$) repräsentativ sind.

8. Erdschutzrelais (9), umfassend mindestens einen Fehlerindikator nach Anspruch 7 und Mittel zum Betätigen einer Abschaltvorrichtung (6) in Abhängigkeit von den Ergebnissen der Mittel zum Auswerten (40) der Vorrichtung zum Bestimmen der Richtung (20) des Indikators.

9. Verfahren zum Bestimmen der Richtung (D, L) eines Erdschluss-Fehlers (10) in einem Mehrphasennetz (1), umfassend das Auslösen infolge des Erhaltens eines Signals (D), das das Vorhandensein des Erdschluss-Fehlers (10) anzeigt, des Bestimmens der Richtung (L) des Fehlers (10), wobei das Bestimmen der Richtung die folgenden Schritte aufweist:

- Erhalten von Signalen, die für einen Betrag von jedem der Phasenströme ($\|I_A\|$, $\|I_B\|$, $\|I_C\|$) über eine Zeitdauer ($T_{acq}$) von mindestens einer Halbperiode des Netzes repräsentativ sind;
- Verarbeiten der Signale, die für den Betrag der Phasenströme ($\|I_A\|$, $\|I_B\|$, $\|I_C\|$) repräsentativ sind, umfassend das Berechnen des Mittelwerts ($M$) der Signale, die für den Betrag von jedem der Phasenströme ($\|I_A\|$, $\|I_B\|$, $\|I_C\|$) über eine vorbestimmte Zeitdauer ($T_{acq}$) repräsentativ sind;
- Auswerten der Ergebnisse der Signalverarbeitung, um anzugeben, ob der erfasste Fehler (D) vorgelagert oder nachgelagert nach der Stelle vorliegt, an der die Signale, die für die Beträge der Phasenströme ($\|I_A\|$, $\|I_B\|$, $\|I_C\|$) repräsentativ sind, erhalten worden sind, durch ein Vergleichen des Mittelwerts ($M$) und der Signale, die für den Betrag von jedem der Phasenströme ($\|I_A\|$, $\|I_B\|$, $\|I_C\|$) repräsentativ sind.

10. Verfahren zum Bestimmen der Richtung nach Anspruch 9, wobei der Schritt des Erhaltens von Signalen, die für den Betrag von jedem der Phasenströme ($\|I_A\|$, $\|I_B\|$, $\|I_C\|$) über eine Zeitdauer ($T_{acq}$) repräsentativ sind, das Erhalten von Signalen, die für jeden der Phasenströme ($I_A$, $I_B$, $I_C$) repräsentativ sind, und das Berechnen ihres Betrags aufweist.

11. Verfahren zum Bestimmen der Richtung nach einem der Ansprüche 9 oder 10, wobei der Schritt des Bereitstellens der Signale, die für die Beträge der Phasenströme ($\|I_A\|$, $\|I_B\|$, $\|I_C\|$) repräsentativ sind, ein Abtasten des Stroms bei einer Frequenz von unter 1 kHz aufweist.

12. Verfahren zum Bestimmen der Richtung nach Anspruch 10, wobei der Schritt des Bereitstellens der Signale, die für die Phasenströme ($I_A$, $I_B$, $I_C$) repräsentativ sind, ein Abtasten des Stroms bei einer Frequenz von über 1 kHz aufweist und ferner die folgenden Schritte aufweist des:

- Erhaltens eines Signals, das für den homopolaren Strom ($I_0$) repräsentativ ist, der in dem Netz über die gleiche Zeitdauer ($T_{acq}$) fließt;
- Berechnens der nicht signierten normalisierten Korrelationskoeffizienten ($r_A$, $r_B$, $r_C$) zwischen den Signalen eines homopolaren Stroms ($I_0$) und von jedem der Phasenströme ($I_A$, $I_B$, $I_C$) über die vorbestimmte Zeitdauer ($T_{acq}$);
- Berechnens des arithmetischen Mittelwerts ($\mu$) und der Standardabweichung ($\sigma$) der Korrelationskoeffizienten ($r_A$, $r_B$, $r_C$);

- Auswertens der Ergebnisse der Signalverarbeitung, um anzugeben, ob der erfasste Fehler (D) vorgelagert oder nachgelagert nach der Stelle vorliegt, an der die Signale, die für die Beträge der Phasenströme ($I_A$, $I_B$, $I_C$) repräsentativ sind, durch ein Vergleichen erhalten worden sind, das den Mittelwert ($\mu$) und die Standardabweichung ($\sigma$) verwendet.

13. Verfahren zum Bestimmen der Richtung nach Anspruch 12, wobei der Schritt des Auswertens das Vergleichen mit Null der Differenz zwischen dem Dreifachen des Quadrats der Standardabweichung ($\sigma$) und dem Quadrat der Differenz zwischen dem Mittelwert ($\mu$) und eins, alternativ das graphische Vergleichen des Mittelwerts ($\mu$) und der Standardabweichung ($\sigma$) mit einer Geradengleichung $y = \frac{1-x}{\sqrt{3}}$ aufweist.

14. Verfahren zum Schützen einer Stromleitung (5) bei dem Auftreten eines Erdschluss-Fehlers (10), umfassend das Betätigen einer Abschaltvorrichtung (6) der Leitung (5), wenn ein Erdschluss-Fehler (10) durch ein Verfahren nach einem der Ansprüche 19 bis 13 nachgelagert nach der Abschaltvorrichtung (6) erkannt worden ist.

## Claims

1. Device (20) for the directional detection of a ground fault (10) in a multiphase network (1), **characterized in that** it includes:

   - first means for receiving signals representative of a norm of the current ($\|I_A\|$, $\|I_B\|$, $\|I_C\|$) of each of the phases;
   - second means (34) for receiving a signal representative of the zero-sequence current ($I_0$) of all of the phases,
   - first means (30) for processing the signals representative of the norm of the current ($\|I_A\|$, $\|I_B\|$, $\|I_C\|$), comprising means (36) for calculating the mean ($M$) of the norms ($\|I_A\|$, $\|I_B\|$, $\|I_C\|$) over a predetermined duration ($T_{acq}$);
   - means (32) for activating said first processing means (30) on the basis of a signal (D) for detecting the occurrence of a ground fault in the network (1), said activation means (32) being associated with the second means (34),
   - first means (40) for interpreting the results of the processing of the signals in order to determine whether the fault is upstream or downstream of the device (20), comprising means for comparing said mean ($M$) with said norms ($\|I_A\|$, $\|I_B\|$, $\|I_C\|$, if just one norm of the phase currents after the occurrence of the fault is higher than the mean of the norms calculated for the three phases, the fault being considered downstream of the detection, if just one norm is lower than the mean ($M$), the fault (10) being considered to be located upstream.

2. Directional detection device (20) according to Claim 1, wherein the means (36) for calculating the mean ($M$) of the norms are associated with means for acquiring the signals for a duration ($T_{acq}$) corresponding to a whole number of half-periods of the network (1).

3. Directional detection device (20) according to either of Claims 1 and 2, wherein the first means for receiving the signals representative of the norm of the current ($\|I_A\|$, $\|I_B\|$, $\|I_C\|$) of each of the phases comprise means for receiving the signals representative of the current ($I_A$, $I_B$, $I_C$) of each of the phases and means (28) for calculating a norm of each of the representative signals, and the first means for receiving signals representative of the currents of each phase ($\|I_A\|$, $\|I_B\|$, $\|I_C\|$) comprise sampling means (26).

4. Directional detection device (20) according to Claim 1, furthermore comprising:

   - third means (22) for receiving signals representative of the current ($I_A$, $I_B$, $I_C$) of each of the phases;
   - second means (30') for processing the signals ($I_0$, $I_A$, $I_B$, $I_C$) representative of current, comprising means (28') for calculating normalized coefficients of correlation ($r_A$, $r_B$, $r_C$) between the signal representative of the zero-sequence current ($I_0$) and each of the signals representative of phase currents ($I_A$, $I_B$, $I_C$) over a predetermined duration ($T_{acq}$), and means (36') for calculating the mean ($\mu$) and the standard deviation ($\sigma$) between the absolute value of the calculated coefficients of correlation ($r_A$, $r_B$, $r_C$);
   - means for activating said second processing means (30') on the basis of a signal (D) for detecting the occurrence of a ground fault in the network (1);
   - second means (40') for interpreting the results of the processing of the signals in order to determine whether the fault is upstream or downstream of the device, comprising means for comparing said mean ($\mu$) and said standard deviation ($\sigma$).

**5.** Directional detection device (20) according to Claim 4, wherein the means for calculating the coefficients of correlation (28') are associated with means for acquiring the signals for a duration ($T_{acq}$) corresponding to a whole number of half-periods of the network (1), and the third means (22) for receiving signals representative of the currents of each phase ($I_A$, $I_B$, $I_C$) comprise sampling means (26') designed to provide a sufficient number of values during the predetermined duration ($T_{acq}$).

**6.** Device according to one of Claims 1 to 5, furthermore comprising means (32) for detecting the occurrence of a ground fault (10) in the network (1), linked to the means for activating the signal processing means (30), comprising a comparator for comparing the signal representative of the zero-sequence current ($I_0$) with a detection threshold ($S_d$).

**7.** Ground fault passage indicator, comprising current sensors ($12_A$, $12_B$, $12_C$) arranged on each phase conductor ($5_A$, $5_B$, $5_C$) of an electrical network (1) to be monitored and comprising a device for the directional detection of a fault (20) according to one of Claims 1 to 6 connected to said current sensors ($12_A$, $12_B$, $12_C$) in order to receive the signals representative of phase current ($I_A$, $I_B$, $I_C$).

**8.** Ground protection relay (9) comprising at least one fault indicator according to Claim 7 and means for actuating a disconnection device (6) on the basis of the results of the interpretation means (40) of the directional detection device (20) of the indicator.

**9.** Method for the directional detection (D, L) of a ground fault (10) in a multiphase network (1), comprising triggering the directional determination (L) of the fault (10) following the acquisition of a signal (D) indicating the presence of said ground fault (10), said directional determination comprising the successive steps of:

- acquiring signals representative of a norm of each of the phase currents ($\|I_A\|$, $\|I_B\|$, $\|I_C\|$) over a duration ($T_{acq}$) of at least one half-period of the network;
- processing the signals representative of the norm of the phase currents ($\|I_A\|$, $\|I_B\|$, $\|I_C\|$), comprising calculating the arithmetic mean ($M$) of the signals representative of the norm of each of the phase currents ($\|I_A\|$, $\|I_B\|$, $\|I_C\|$) over the predetermined duration ($T_{acq}$);
- interpreting the results of the processing of the signals, in order to indicate whether the detected fault (D) is situated downstream or upstream of the location at which the signals representative of the norms of the phase currents ($\|I_A\|$, $\|I_B\|$, $\|I_C\|$) were acquired, through a comparison between said mean ($M$) and said signals representative of the norm of each of the phase currents ($\|I_A\|$, $\|I_B\|$, $\|I_C\|$).

**10.** Directional detection method according to Claim 9, wherein the step of acquiring signals representative of the norm of each of the phase currents ($\|I_A\|$, $\|I_B\|$, $\|I_C\|$) over a duration ($T_{acq}$) comprises acquiring signals representative of each of the phase currents ($I_A$, $I_B$, $I_C$) and calculating their norm.

**11.** Directional detection method according to either of Claims 9 and 10, wherein the step of providing signals representative of the norms of the phase currents ($\|I_A\|$, $\|I_B\|$, $\|I_C\|$) includes sampling the current at a frequency lower than 1 kHz.

**12.** Directional detection method according to Claim 10, wherein the step of providing the signals representative of the phase currents ($I_A$, $I_B$, $I_C$) includes sampling the current at a frequency higher than 1 kHz, and furthermore comprising the successive steps of:

- acquiring a signal representative of the zero-sequence current ($I_0$) flowing in the network over the same duration ($T_{acq}$);
- calculating the unsigned normalized coefficients of correlation ($r_A$, $r_B$, $r_C$) between the zero-sequence current signals ($I_0$) and each of the phase currents ($I_A$, $I_B$, $I_C$) over the predetermined duration ($T_{acq}$);
- calculating the arithmetic mean ($\mu$) and the standard deviation ($\sigma$) of said coefficients of correlation ($r_A$, $r_B$, $r_C$);
- interpreting the results of the processing of the signals in order to indicate whether the detected fault (D) is situated downstream or upstream of the location at which the signals representative of the phase currents ($I_A$, $I_B$, $I_C$) were acquired through a comparison using said mean ($\mu$) and said standard deviation ($\sigma$).

**13.** Directional detection method according to Claim 12, wherein the interpretation step comprises comparing, with zero, the difference between three times the square of the standard deviation ($\sigma$) and the square of the difference between the mean ($\mu$) and one, or alternatively graphically comparing the mean ($\mu$) and the standard deviation ($\sigma$) with a

straight line having the equation $y = \frac{1-x}{\sqrt{3}}$.

14. Method for protecting a current line (5) upon the occurrence of a ground fault (10), comprising actuating a device (6) for disconnecting said line (5) if a ground fault (10) has been detected by a method according to one of Claims 19 to 13 downstream of said disconnection device (6).

**Fig.1**

Fig.2A

Fig.2B

Fig.2C

Fig.3

**Fig.4A**

**Fig.4B**

Fig.5

**EP 2 169 799 B1**

## RÉFÉRENCES CITÉES DANS LA DESCRIPTION

**Documents brevets cités dans la description**

- EP 1475874 A

- EP 1890165 A